# EUROPEAN PATENT SPECIFICATION

(11) **EP 3 588 367 B1**
(45) Date of publication and mention of the grant of the patent: **10.05.2023**
(21) Application number: 18789921.6
(22) Date of filing: 13.04.2018
(51) Int. Cl.: H01L 27/12, G09G 3/32

(54) **DISPLAY SCREEN, DISPLAY APPARATUS, AND MOBILE TERMINAL**
ANZEIGEBILDSCHIRM, ANZEIGEVORRICHTUNG UND MOBILES ENDGERÄT
ÉCRAN D'AFFICHAGE, APPAREIL D'AFFICHAGE, ET TERMINAL MOBILE

(30) Priority: 27.04.2017 CN 201710289971
(43) Date of publication of application: 01.01.2020
(73) Proprietor: GUANGDONG OPPO MOBILE TELECOMMUNICATIONS CORP., LTD., Wusha, Chang'an Dongguan, Guangdong 523860 (CN)
(72) Inventor: YANG, Le, Dongguan Guangdong 523860 (CN); ZHANG, Haiping, Dongguan Guangdong 523860 (CN)
(74) Representative: Manitz Finsterwald Patent- und Rechtsanwaltspartnerschaft mbB
(86) International application number: PCT/CN2018/083051
(87) International publication number: WO 2018/196637

(56) References cited:
- EP-A1- 3 382 586
- CN-A- 105 702 176
- CN-A- 105 977 314
- CN-A- 106 022 292
- CN-A- 106 095 211
- CN-A- 107 194 321
- US-A1- 2003 174 870
- US-A1- 2014 047 706
- US-A1- 2015 331 508
- US-A1- 2016 132 713

## Description

### TECHNICAL FIELD

This disclosure relates to the field of display technologies, and more particularly to a display screen, a display device, and a mobile terminal.

### BACKGROUND

In order to avoid affecting the display of a display screen, a fingerprint recognition module is disposed outside a display area of the display screen. However, such structural design makes a screen-to-body ratio of the display area (i.e., a ratio of the display area to the whole display screen) small, which affects user experience. In order to avoid modifying the existing structure of the display screen, it has been proposed to arrange the fingerprint recognition module under the display screen. In such an arrangement, a display layer is driven, by a driving component, to display an image in the display screen. However, the driving component tends to block signals induced by the fingerprint module, resulting in reduced efficiency in fingerprint recognition of the fingerprint module, and providing poor user experience. Such an arrangement suffering from the blocking of signals is known from US 2003/174870 A1 (KIM CHOONG HOO [KR] ET AL) 18 September 2003 (2003-09-18).

### SUMMARY

According to embodiments of the present invention, a display screen, a display device, and a mobile terminal are provided, which can improve light transmittance of the display screen, thereby improving the accuracy of fingerprint collection and recognition of an optical fingerprint module.

According to embodiments of the present disclosure, invention, a display screen according to claim 1 is provided. The display screen includes a display layer. The display layer has a fingerprint recognition area and a peripheral area adjacent to the fingerprint recognition area. The fingerprint recognition area is provided with multiple first driving components. The peripheral area is provided with multiple second driving components. An interval at which the multiple first driving components are arranged is greater than an interval at which the multiple second driving components are arranged.

According to embodiments of the present invention, a display device according to claim 12 is provided. The display device includes the above display screen, an optical fingerprint module, and a frame. The display screen and the optical fingerprint module are fixed on the frame. The optical fingerprint module is located on one side of the display screen intended to away from a user. The optical fingerprint module is located in a position corresponding to the fingerprint recognition area, where the fingerprint recognition area is configured to allow light signals transmitted or received by the optical fingerprint module to pass through.

According to embodiments of the present invention, a mobile terminal according to claim 14 is provided. The mobile terminal includes the above display device.

By increasing the interval at which the first driving components corresponding to the fingerprint recognition area are arranged, a light-shielding area of the first driving components corresponding to the fingerprint recognition area is reduced. Accordingly, light transmittance of the fingerprint recognition area can be increased, which allows more induced signals transmitted and received by a fingerprint module to pass through, and so efficiency of fingerprint collection and recognition of the fingerprint module can be improved.

### BRIEF DESCRIPTION OF THE DRAWINGS

In order to describe technical solutions of the present disclosure more clearly, the following will give a brief description of accompanying drawings used for describing the embodiments of the present disclosure. Apparently, accompanying drawings described below are merely some embodiments of the present disclosure. Those of ordinary skill in the art can also obtain other accompanying drawings based on the accompanying drawings described below without creative efforts.
FIG. 1 is a schematic structural diagram illustrating a display screen according to an embodiment of the present disclosure.
FIG. 2 is a schematic structural diagram illustrating a display screen according to another embodiment of the present disclosure.
FIG. 3 is a sectional view of the display screen illustrated in FIG. 1 along a line *AA'.*
FIG. 4 is a schematic structural diagram illustrating a display screen according to a first embodiment of the present disclosure.
FIG. 5 is a schematic structural diagram illustrating a display screen according to the first embodiment of the present disclosure.
FIG. 6 is a schematic structural diagram illustrating a display screen according to a second embodiment of the present disclosure.
FIG. 7 is a schematic structural diagram illustrating a display screen according to a third embodiment of the present disclosure.
FIG. 8 is a schematic structural diagram illustrating a display screen according to a fourth embodiment of the present disclosure.
FIG. 9 is a schematic structural diagram illustrating a display screen according to a fifth embodiment of the present disclosure.
FIG. 10 is a schematic structural diagram illustrating a display screen according to the fifth embodiment of the present disclosure.
FIG. 11 is another schematic structural diagram illustrating a display screen according to a sixth embodiment of the present disclosure.
FIG. 12 is a schematic structural diagram illustrating a display screen according to an embodiment of the present disclosure.
FIG. 13 is a schematic structural diagram illustrating a display screen according to an embodiment of the present disclosure.
FIG. 14 is a schematic structural diagram illustrating a display device according to an embodiment of the present disclosure.
FIG. 15 is a schematic structural diagram illustrating a mobile terminal according to an embodiment of the present disclosure.

### DETAILED DESCRIPTION

Technical solutions in embodiments of the present disclosure are described in detail in combination with the accompanying drawing.

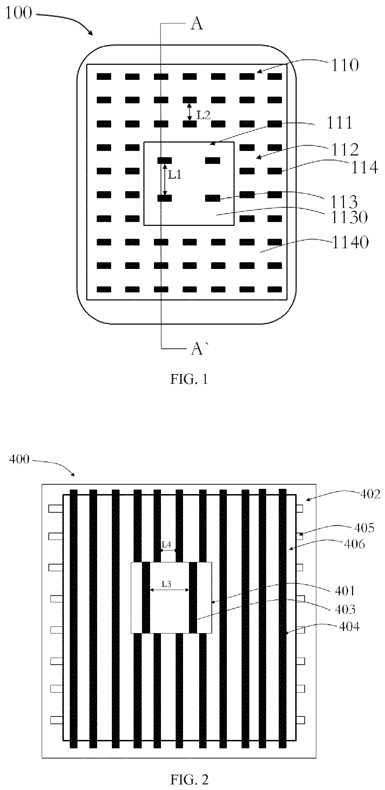

FIG. 1 illustrates a display screen 100 according to an embodiment of the present disclosure. Referring to FIG. 1, the display screen 100 includes a display layer 110 configured to display an image. The display layer 110 has a fingerprint recognition area 111 and a peripheral area 112 adjacent to the fingerprint recognition area 111. The fingerprint recognition area 111 is provided with multiple first driving components 113 and has a first transparent area 1130 among the multiple first driving components 113. The first transparent area 1130 is configured to allow induced signals transmitted and received by a fingerprint module to pass through. The fingerprint module may be an optical fingerprint module. The induced signals may be light signals. The peripheral area 112 is provided with multiple second driving components 114 and has a second transparent area 1140 among the multiple second driving components 114. An interval *L1* at which the first driving components 113 are arranged is greater than an interval L2 at which the second driving components 114 are arranged, and a ratio of an area of the first transparent area 1130 to an area of the fingerprint recognition area 111 is greater than a ratio of an area of the second transparent area 1140 to an area of the peripheral area 112.

The display screen 100 is an organic light-emitting diode (OLED) display screen 100. As an example, the display screen is an active-matrix OLED display screen. The first driving component 113 and the second driving component 114 are both thin-film transistors. For example, the first driving component 113 is a first thin-film transistor and the second driving component 114 is a second thin-film transistor. The first thin-film transistor 113 and the second thin-film transistor 114 may have the same structure. The first thin-film transistor 113 and the second thin-film transistor 114 can be made of the same material and by the same manufacturing process. The first driving components 113 are arranged in an array in the fingerprint recognition area 111. The second driving components 114 are arranged in an array in the peripheral area 112.

Referring to FIG. 2, for example, a display screen 400 is a passive-matrix OLED display screen. A fingerprint recognition area 401 is provided with multiple first driving components 403. The first driving component 403 may be a first anode strip. A peripheral area 402 is provided with multiple second driving components 404. The second driving component 404 may be a second anode strip 404. Second anode strips 404 are disposed on a same layer as first anode strips 403, the second anode strips 404 arc spaced apart from each other, and the first anode strips 403 are spaced apart from each other. The display screen 400 may further include multiple cathode strips 405. The cathode strips 405 are spaced apart from each other and perpendicular to the second anode strips 404 and the first anode strips 403. The display screen 400 may further include an organic light-emitting layer 406 disposed between the first anode strips 403 and the cathode strips 405. The first anode strips 403 and the second anode strips 404 are made of opaque metal material. In this embodiment, to increase light transmittance of the fingerprint recognition area 401, an interval *L3* at which the first anode strips 403 are arranged is set to be greater than an interval *L4* at which the second anode strips 404 are arranged, as such, more light signals can pass through the display screen 400 to be received by a fingerprint module, and efficiency of fingerprint collection and recognition of the fingerprint module can be improved.

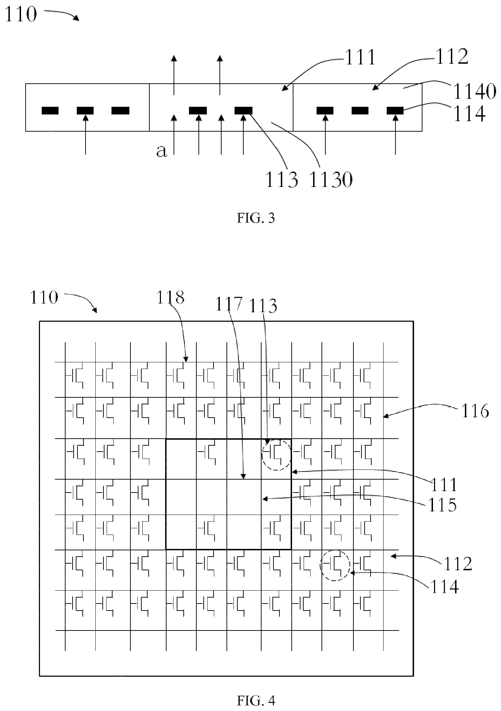

FIG. 3 is a sectional view of the display screen 100 illustrated in FIG. 1 along the line *AA'.* Referring to FIG. 3, since a source, a gate, and a drain of a thin-film transistor are made of metals such as Al/Mo/Cu or an alloy thereof, the source, the gate, and the drain of the thin-film transistor do not allow light *a* to pass through. Therefore, if an optical fingerprint module is disposed on one side of the display screen 100 intended to away from a user, thin-film transistors will block light signals transmitted or received by the optical fingerprint module from passing through, which reduces the intensity of light signals received by the optical fingerprint module and results in a decrease in accuracy and efficiency of fingerprint recognition. An interval at which the first thin-film transistors 113 are arranged is greater than an interval at which the second thin-film transistors 114 are arranged. A light-shielding area (i.e., an area corresponding to the first thin-film transistors 113) corresponding to the fingerprint recognition area 111 is smaller than a light-shielding area corresponding to the peripheral area 112, and a transparent area (i.e., the first transparent area 1130) corresponding to the fingerprint recognition area 111 is larger than a transparent area corresponding to the peripheral area 112. Thus, light transmittance of the fingerprint recognition area 111 is larger than that of the peripheral area 112. With such fingerprint recognition area 111, in the display screen 100, the loss of the light signals transmitted by the optical fingerprint module to be projected onto patterns of a finger can be reduced, which ensures that more light signals can be projected onto the patterns of the finger and then reflected by the patterns of the finger. Moreover, in the display screen 100, the loss of reflected light signals can be reduced either, which ensures that more light signals can be projected to the optical fingerprint module. The more light signals received by the optical fingerprint module, the higher recognition accuracy of the fingerprint recognition.

Referring to FIG. 4, the fingerprint recognition area 111 is further provided with multi-column first scan lines 115. The first scan lines 115 are electrically coupled with gates of the first thin-film transistors 113 to control on/off states of the first thin-film transistors 113. The peripheral area 112 is further provided with second scan lines 116. The second scan lines 116 are extended in a same direction as the first scan lines 115. The second scan lines 116 are electrically coupled with gates of the second thin-film transistors 114 to control on/off states of the first thin-film transistors 113. The first scan lines 115 are electrically coupled with the second scan lines 116, in this way, once the display screen 100 enables a scan line, it is possible to simultaneously control the first thin-film transistors 113 electrically coupled with the first scan lines 115 and the second thin-film transistors 114 electrically coupled with the second scan lines 116.

In this embodiment, the first scan line 115 and the second scan line 116 may have the same structure. The first scan line 115 and the second scan line 116 are made of the same material and manufactured in a same process.

Referring to FIG. 4, the fingerprint recognition area 111 is further provided with multi-row first data lines 117. An extension direction of the first data lines 117 intersects an extension direction of the first scan lines 115. For example, the extension direction of the first data lines 117 is perpendicular to the extension direction of the first scan lines 115. The first data line 117 is electrically coupled with the source of the first thin-film transistor 113 to write voltage signals at the source of the first thin-film transistor 113. The peripheral area 112 is further provided with second data lines 118. The second data line 118 is extended in a same direction as the first data line 117. The second data line 118 is electrically coupled with the source of the second thin-film transistor 114 to write voltage signals at the source of the second thin-film transistor 114. The first data line 117 is extended in a same direction as the second data line 118. The first data line 117 is electrically coupled with the second data line 118.

In this embodiment, the first data lines 117 and the second data lines 118 may have the same structure, and the first data lines 117 and the second data lines 118 can be made of the same material and manufactured in a same process.

In this embodiment, the manner in which the first scan lines 115 are arranged and the manner in which the second scan lines 116 are arranged can be the same or different. Similarly, the manner in which the first data lines 117 are arranged and the manner in which the second data lines 118 are arranged can be the same or different. A first embodiment in which the first scan lines 115 and the second scan lines 116 are arranged in the same manner and the first data lines 117 and the second data lines 118 are arranged in the same manner will be described in detail below.

### First embodiment

Referring to FIG. 4, the manner in which the first scan lines 115 are arranged is the same as the manner in which the second scan lines 116 are arranged. The first scan line 115 is electrically coupled with the second scan line 116. The first scan line 115 is parallel to the second scan line 116. The manner in which the first data lines 117 are arranged is the same as the manner in which the second data lines 118 are arranged. The first data line 117 is electrically coupled with the second data line 118. The first data line 117 is parallel to the second data line 118. An interval at which the first thin-film transistors 113 are arranged is greater than an interval at which the second thin-film transistors 114 are arranged. With such structural design, a light-shielding area corresponding to the fingerprint recognition area 111 can be reduced by increasing the interval at which the first thin-film transistors 113 are arranged, and light transmittance of the fingerprint recognition area 111 can be increased, as a result, more light signals can pass through the display screen 100. Accordingly, more light signals can be received by the fingerprint module, and efficiency of fingerprint collection and recognition of the fingerprint module can be improved.

In this embodiment, the fingerprint recognition area 111 corresponds to a part of the display layer 110. The fingerprint recognition area 111 is in a central area of the display layer 110. The fingerprint recognition area 111 is surrounded by the peripheral area 112. With such structural design, it is possible to adapt to a user's hand-held posture while increasing light transmittance of the fingerprint recognition area 111, which facilitates the user to unlock with fingerprint, thereby improving user experience. For example, when a user tries to unlock a mobile terminal with the mobile terminal placed in a palm of his or her hand, since the location of the fingerprint of the thumb with respect to the mobile terminal corresponds to a central area of the display layer 110, the mobile terminal can be unlocked when the user simply put his or her thumb directly on the fingerprint recognition area 111 without moving the thumb.

There is no restriction on the manner in which the first thin-film transistors 113 are arranged. In an embodiment, the first thin-film transistors 113 are arranged in an array in the fingerprint recognition area 111, to ensure that the display screen 100 has uniform display brightness.

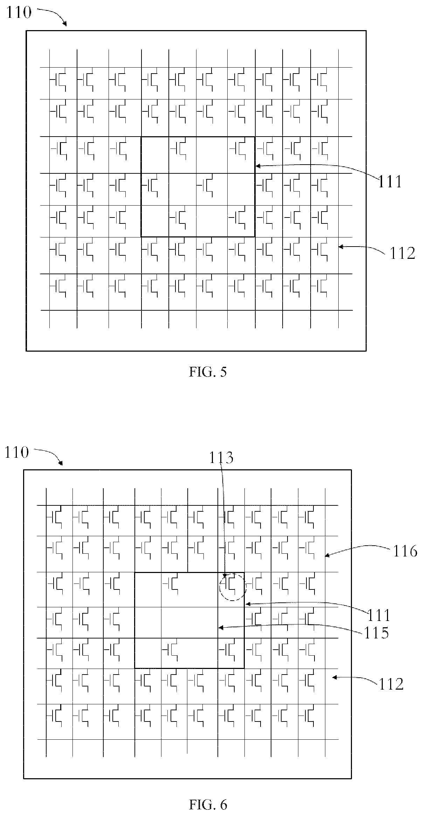

The interval at which the first thin-film transistors 113 are arranged is not restricted herein and can be determined according to actual needs. Referring to FIG. 4, the interval at which the first thin-film transistors 113 are arranged is greater than the interval at which the second thin-film transistors 114 are arranged. For instance, arrangement density of the first thin-film transistors 113 is one third of arrangement density of the second thin-film transistors 114. Referring to FIG. 5, the arrangement density of the first thin-film transistors 113 is one half of the arrangement density of the second thin-film transistors 114. As an example, no first thin-film transistor 113 is arranged in the fingerprint recognition area 111. As another example, it is desirable to make the resolution of the fingerprint recognition area 111 close to the resolution of the peripheral area 112, as such, the resolution of different areas perceived by user's eyes is almost the same and therefore, user's visual experience will not be affected. To this end, the interval at which the first thin-film transistors 113 are arranged can be appropriately increased.

Since the first scan lines 115, the second scan lines 116, the first data lines 117, and the second data lines 118 are made of metals such as Al/Mo/Cu or an alloy thereof, no light signal can pass through. Therefore, the first scan lines 115 corresponding to the fingerprint recognition area 111 can also block light signals of the fingerprint module from passing through, resulting in decreased fingerprint recognition efficiency.

According to embodiments of the present disclosure, light transmittance of the fingerprint recognition area 111 can be increased by modifying the manner in which the first scan lines 115 and the first data lines 117 corresponding to the fingerprint recognition area 111 are arranged. The following is explained in detail in a second embodiment ~ a fourth embodiment.

### Second embodiment

Referring to FIG. 6, an interval at which the first scan lines 115 are spaced apart is greater than an interval at which the second scan lines 116 are spaced apart. The first data lines 117 are arranged in a manner same as the second data lines 118. The first data line 117 is electrically coupled with the second data line 118. The first data line 117 is parallel to the second data line 118. The interval at which the first thin-film transistors 113 are arranged is greater than the interval at which the second thin-film transistors 114 are arranged. Compared with the first embodiment, with such structural design, a light-shielding area corresponding to the fingerprint recognition area 111 can be further reduced by increasing the interval at which the first thin-film transistors 113 are arranged and the interval at which the first scan lines 115 are spaced apart, as such, light transmittance of the fingerprint recognition area 111 can be further increased, and more light signals can pass through the display screen 100. Accordingly, more light signals can be received by the fingerprint module, and efficiency of fingerprint collection and recognition of the fingerprint module can be improved.

### Third embodiment

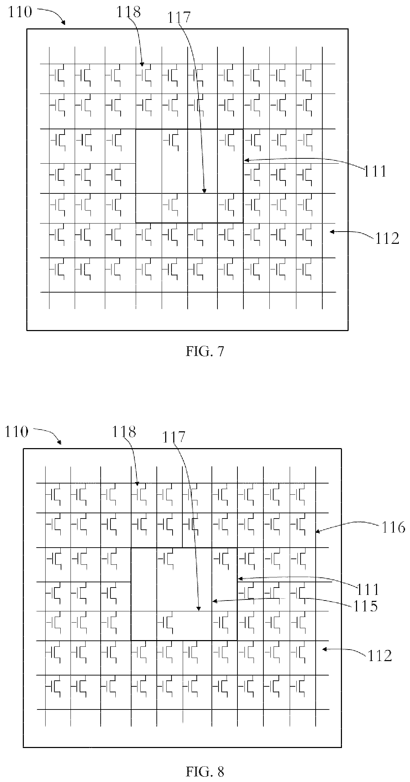

Referring to FIG. 7, the first scan lines 115 are arranged in a manner same as the second scan lines 116. The first scan line 115 is electrically coupled with the second scan line 116. The first scan line 115 is parallel to the second scan line 116. An interval at which the first data lines 117 are spaced apart is greater than an interval at which the second data lines 118 are spaced apart. The interval at which the first thin-film transistors 113 are arranged is greater than the interval at which the second thin-film transistors 114 are arranged. Compared with the first embodiment, with such structural design, a light-shielding area corresponding to the fingerprint recognition area 111 can be further reduced by increasing the interval at which the first thin-film transistors 113 are arranged and the interval at which the first data lines 117 are spaced apart, as such, light transmittance of the fingerprint recognition area 111 can be further increased, and more light signals can pass through the display screen 100. Accordingly, more light signals can be received by the fingerprint module, and efficiency of the fingerprint collection and recognition of the fingerprint module can be improved.

### Fourth embodiment

Referring to FIG. 8, the interval at which the first data lines 117 are spaced apart is greater than the interval at which the second data lines 118 are spaced apart. The interval at which first scan lines 115 are spaced apart is greater than interval at which the second scan lines 116 are spaced apart. The interval at which the first data lines 117 are spaced apart is greater than the interval at which the second data lines 118 are spaced apart. Compared with the first embodiment, with such structural design, a light-shielding area corresponding to the fingerprint recognition area 111 can be further reduced by increasing the interval at which the first thin-film transistors 113 are arranged, the interval at which the first data lines 117 are spaced apart, and the interval at which the first scan lines 115 are spaced apart, as such, light transmittance of the fingerprint recognition area 111 can be further increased, and more light signals can pass through the display screen 100. Accordingly, more light signals can be received by the fingerprint module, and efficiency of fingerprint collection and recognition of the fingerprint module can be improved.

Position of the fingerprint recognition area 111 is not limited in the present disclosure. For instance, the fingerprint recognition area 111 and the optical fingerprint module correspond to each other in position. For example, the optical fingerprint module can be located directly below the fingerprint recognition area 111 (in a thickness direction of the display screen 100, and the optical fingerprint module is located on one side of the display screen 100 intended to away from the user).

The size of the fingerprint recognition area 111 is not limited in the present disclosure. For example, the size of the fingerprint recognition area 111 is greater than the size of a light induction area on the optical fingerprint module. The fingerprint recognition area 111 may correspond to a part of the display layer 110. The fingerprint recognition area 111 may correspond to a central area of the display layer 110, or may correspond to an edge area of the display layer 110. As another example, the fingerprint recognition area 111 may correspond to the whole display layer 110. The following will be detailed in specific embodiments.

### Fifth embodiment

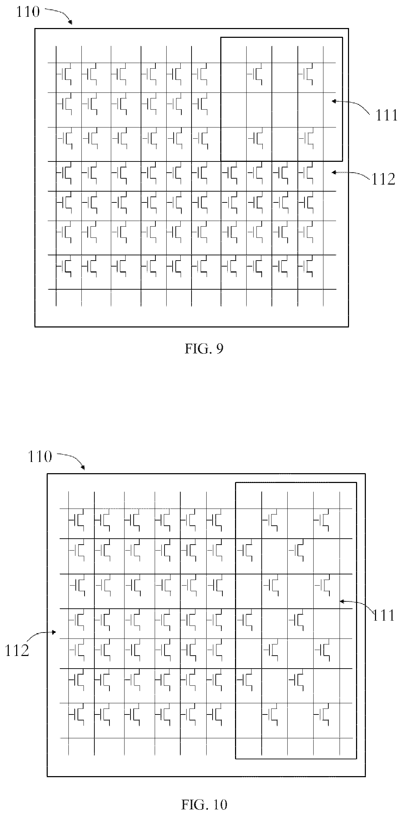

FIG. 9 and FIG. 10 are schematic structural diagrams illustrating a display screen 100 according to a sixth embodiment of the present disclosure. The fingerprint recognition area 111 corresponds to a part of the display layer 110. For example, the fingerprint recognition area 111 corresponds to an edge area of the display layer 110 and the peripheral area 112 is adjacent to the fingerprint recognition area 111. In the first embodiment, the fingerprint recognition area 111 corresponds to a central area of the display layer 110, and some second scan lines 116 are divided into two parts by the fingerprint recognition area 111. If no first scan line 115 is provided to connect these two parts of the second scan line 116 separated by the fingerprint recognition area 111, the two parts of the second scan line 116 need to be wired around the fingerprint recognition area 111, additional wires, which bypass the fingerprint recognition area 111, will be required to couple the two parts of the second scan line 116 separated, which makes it difficult to arrange the second scan lines 116. In this embodiment, the fingerprint recognition area 111 is set to be correspond to the edge area of the display layer 110 to avoid the second scan line 116 being divided into two parts. As such, the second scan lines 116 can be arranged easily with increased light transmittance of the fingerprint recognition area 111.

### Sixth embodiment

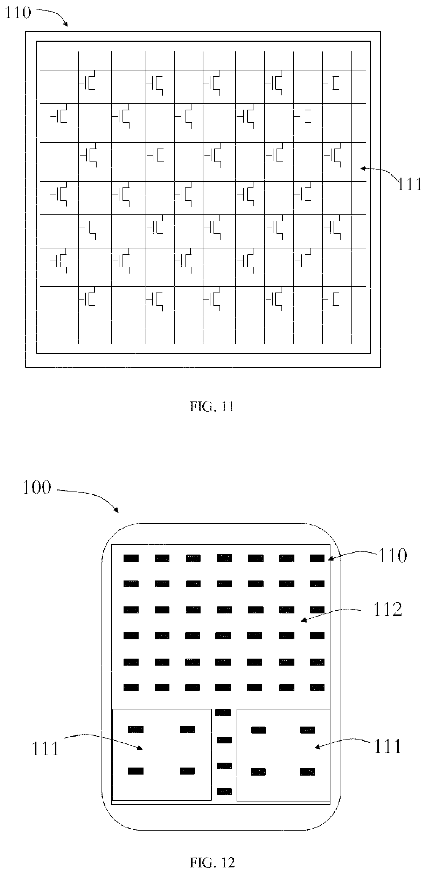

FIG. 11 is a schematic structural diagram illustrating a display screen 100 according to a seventh embodiment of the present disclosure. Referring to FIG. 11, the fingerprint recognition area 111 corresponds to the whole display layer 110. With such structural design, light transmittance of the fingerprint recognition area 111 can be increased. In addition, an area for fingerprint recognition becomes larger and therefore, inaccuracy and/or failure of fingerprint recognition due to poor finger placement can be avoided or reduced. Furthermore, inaccuracy and/or failure of fingerprint recognition due to existence of a foreign material in the fingerprint recognition area 111 of the display screen 100 can be avoided or reduced. Moreover, fingerprint recognition can be implemented in any area of the display layer 110, thereby improving user experience.

The number of the fingerprint recognition area 111 is not limited in the present disclosure. Referring to FIG. 12, the fingerprint recognition area 111 may be embodied as multiple fingerprint recognition areas. The multiple fingerprint recognition areas 111 are distributed in an area corresponding to the whole display layer 110. With such structural design, inaccuracy and/or failure of fingerprint recognition due to existence of a foreign material in one or more of the fingerprint recognition areas 111 of the display screen 100 can be avoided or reduced. Moreover, fingerprint recognition can be implemented in any area of the display layer 110, which can improve user experience.

The shape of the fingerprint recognition area 111 is not limited in the present disclosure. The fingerprint recognition area 111 can be circular, square, elliptical, irregular shape, or the like.

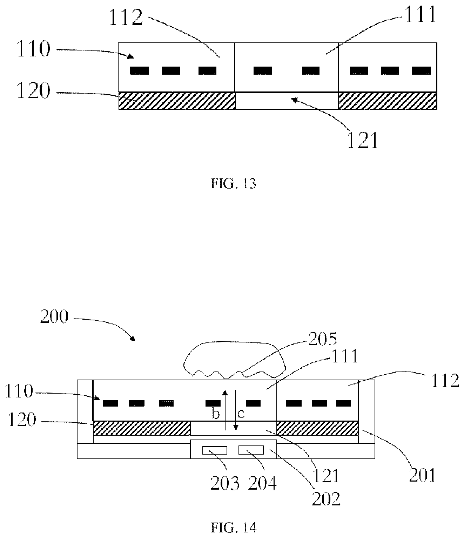

Referring to FIG. 13, the display screen 100 may further include a light-shielding layer 120. The light-shielding layer 120 is disposed on one side of the display layer 110 intended to away from a user. The light-shielding layer 120 defines a through hole 121. The through hole 121 is located in a position corresponding to the fingerprint recognition area 111, whereby the optical fingerprint module can transmit and receive light signals through the fingerprint recognition area 111 and the through hole 121. In an embodiment, the shape and size of the through hole 121 is the same as that of the fingerprint recognition area 111. An orthographic projection area of the through hole 121 on the display layer 110 coincides with the fingerprint recognition area 111.

The light-shielding layer 120 may be a foam layer. The foam layer is configured to block lights from passing through the display layer 110, to hide internal structures disposed under the display layer 110, and to exhibit a color of the light-shielding layer 120 when the display layer 110 does not emit lights. The light-shielding layer 120 can be black, white, or other opaque colors. The foam layer defines the through hole 121, so lights can pass through the light-shielding layer 120.

FIG. 14 illustrates a display device 200 according to an embodiment of the present disclosure. The display device 200 includes the display screen 100 according to any of the above embodiments, an optical fingerprint module 202, and a frame 201. The display screen 100 and the optical fingerprint module 202 are fixed on the frame 201. The optical fingerprint module 202 is located on one side of the display screen 100 intended to away from a user. The optical fingerprint module 202 is located in a position corresponding to the fingerprint recognition area 111, whereby light signals transmitted or received can pass through the fingerprint recognition area 111. The optical fingerprint module 202 includes a light emitter 203 and a light inductor 204. The light emitter 203 is configured to emit light signals *b* and the light inductor 204 is configured to receive light signals *c*. When a finger is in contact with a surface of the display screen 100, lights transmitted from the light emitter 203 form incident lights *b,* and incident lights *b* sequentially pass through the through hole 121 and the fingerprint recognition area 111 of the display layer 110 to be projected onto patterns of a finger 205. Since the display layer 110 corresponding to the fingerprint recognition area 111 is provided with first thin-film transistors 113, first scan lines 115, and first data lines 117 arranged at large intervals, transmittance in the display layer of light signals *b* can be improved, and the intensity of incident lights *b* projected onto the patterns of the finger 205 can be increased. Accordingly, the intensity of reflected lights *c* formed from incident lights *b* reflected by the patterns of the finger 205 can also be increased. When reflected lights *c*, which is formed from reflection of the patterns of the finger 205, sequentially pass through the fingerprint recognition area 111 and the through hole 121 to be projected to the light inductor 204, transmittance of light signals *c* in the fingerprint recognition area 111 of the display layer 110 can also be increased, and intensity of light signals c received by the light inductor 204 can be increased, thereby increasing the accuracy of fingerprint recognition of the optical fingerprint module 202.

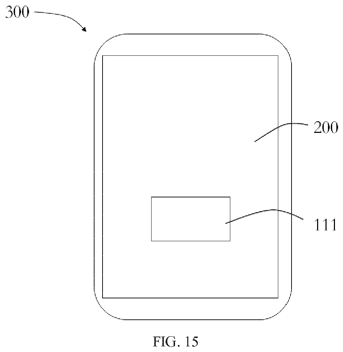

FIG. 15 illustrates a mobile terminal 300 according to an embodiment of the present disclosure. Referring to FIG. 15, the mobile terminal 300 includes the above display device 200. The display device 200 includes a display screen 100 and an optical fingerprint module 202 disposed on one side of the display screen 100 intended to away from a user. The display screen 100 has a fingerprint recognition area 111. By providing, corresponding to the fingerprint recognition area 111, the first thin-film transistors 113, the first scan lines 115, and the first data lines 117 which are arranged at a larger interval, light transmittance of the fingerprint recognition area 111 can be increased. The optical fingerprint module 202 is located at a position corresponding to the fingerprint recognition area 111, as such, the intensity of light signals transmitted by the optical fingerprint module 202 to patterns of a finger 205 can be increased. Accordingly, the intensity of light signals reflected by the patterns of a finger 205 can be increased. Therefore, the accuracy of fingerprint recognition of the optical fingerprint module 202 can be improved.

## Claims

1. A display screen (100, 400), comprising a display layer (110), the display layer having a fingerprint recognition area (111, 401) and a peripheral area (112, 402) adjacent to the fingerprint recognition area, the fingerprint recognition area being provided with a plurality of first driving components (113, 403), the peripheral area being provided with a plurality of second driving components (114, 404), an interval (L1, L3) at which the plurality of first driving components are arranged being greater than an interval (L2, L4) at which the plurality of second driving components are arranged to increase light transmittance of the fingerprint recognition area, wherein the fingerprint recognition area allows light signals to pass through;
wherein the display screen (100, 400) is an active-matrix OLED display screen or a passive-matrix OLED display screen; the first driving components are first thin-film transistors, and the second driving components are second thin-film transistors when the display screen (100, 400) is the active-matrix OLED display screen; the first driving components are first anode strips, and the second driving components are second anode strips when the display screen (100, 400) is the passive-matrix OLED display screen.

2. The display screen of claim 1, wherein the first thin-film transistors are arranged in an array in the fingerprint recognition area.

3. The display screen of claim 2, wherein an area among the first thin-film transistors is a transparent area (1130), and the transparent area is configured to allow light signals transmitted or received by an optical fingerprint module (202) to pass through.

4. The display screen of claim 3, wherein the fingerprint recognition area is further provided with first scan lines (115) electrically coupled with the first thin-film transistors, the peripheral area is further provided with second scan lines (116) electrically coupled with the second thin-film transistors, and an interval at which the first scan lines are spaced apart is greater than or equal to an interval at which the second scan lines are spaced apart.

5. The display screen of claim 4, wherein the first scan lines are extended in a same direction as the second scan lines, and the first scan lines are electrically coupled with the second scan lines.

6. The display screen of claim 5, wherein the fingerprint recognition area is further provided with first data lines (117) electrically coupled with the first thin-film transistors, the peripheral area is further provided with second data lines (118) electrically coupled with the second thin-film transistors, and an interval at which the first data lines are spaced apart is greater than or equal to an interval at which the second data lines are spaced apart.

7. The display screen of claim 6, wherein the first data lines are extended in a same direction as the second data lines, and the first data lines are electrically coupled with the second data lines.

8. The display screen of claim 7, wherein the fingerprint recognition area corresponds to a part of the display layer and corresponds to an edge area of the display layer, and the peripheral area is adjacent to the fingerprint recognition area.

9. The display screen of claim 1, wherein the fingerprint recognition area corresponds to the whole display layer.

10. The display screen of any of claims 1 to 9, further comprising a light-shielding layer (120), wherein the light-shielding layer is disposed on one side of the display layer away from a user and defines a through hole, wherein the through hole is located in a position corresponding to the fingerprint recognition area, and the optical fingerprint module is configured to transmit and receive light signals through the through hole.

11. The display screen of claim 10, wherein the through hole has an orthographic projection area on the display layer coincident with the fingerprint recognition area.

12. A display device (200), comprising the display screen according to any of claims 1 to 11, an optical fingerprint module (202), and a frame (201), wherein the display screen and the optical fingerprint module are fixed on the frame, the optical fingerprint module is located on one side of the display screen away from a user, the optical fingerprint module is located in a position corresponding to the fingerprint recognition area, wherein the fingerprint recognition area is configured to allow light signals transmitted or received by the optical fingerprint module to pass through.

13. The display device of claim 12, wherein the optical fingerprint module comprises a light emitter (203) and a light inductor (204), the light emitter is configured to emit light signals and the light inductor is configured to receive light signals, wherein lights emitted by the light emitter pass through the fingerprint recognition area to be projected onto patterns of a finger when the finger is in contact with a surface of the display screen.

14. A mobile terminal (300), comprising the display device according to claim 12 or 13.

## Patentansprüche

1. Anzeigebildschirm (100, 400), der eine Anzeigeschicht (110) umfasst, wobei die Anzeigeschicht einen Fingerabdruckerkennungsbereich (111, 401) und einen Peripheriebereich (112, 402) angrenzend zu dem Fingerabdruckerkennungsbereich aufweist, wobei der Fingerabdruckerkennungsbereich mit einer Vielzahl von ersten Ansteuerkomponenten (113, 403) versehen ist, der Peripheriebereich mit einer Vielzahl von zweiten Ansteuerkomponenten (114, 404) versehen ist, ein Intervall (L1, L3), mit dem die Vielzahl von ersten Ansteuerkomponenten angeordnet sind, größer ist als ein Intervall (L2, L4), mit dem die Vielzahl von zweiten Ansteuerkomponenten angeordnet sind, um die Lichtdurchlässigkeit des Fingerabdruckerkennungsbereichs zu erhöhen, wobei der Fingerabdruckerkennungsbereich Lichtsignalen ermöglicht, durchzulaufen;
wobei der Anzeigebildschirm (100, 400) ein Aktivmatrix-OLED-Anzeigebildschirm oder ein Passivmatrix-OLED-Anzeigebildschirm ist; die ersten Ansteuerkomponenten erste Dünnfilmtransistoren sind und die zweiten Ansteuerkomponenten zweite Dünnfilmtransistoren sind, wenn der Anzeigebildschirm (100, 400) der Aktivmatrix-OLED-Anzeigebildschirm ist; die ersten Ansteuerkomponenten erste Anodenstreifen sind und die zweiten Ansteuerkomponenten zweite Anodenstreifen sind, wenn der Anzeigebildschirm (100, 400) der Passivmatrix-OLED-Anzeigebildschirm ist.

2. Anzeigebildschirm nach Anspruch 1, wobei die ersten Dünnfilmtransistoren in einem Array im Fingerabdruckerkennungsbereich angeordnet sind.

3. Anzeigebildschirm nach Anspruch 2, wobei ein Bereich zwischen den ersten Dünnfilmtransistoren ein transparenter Bereich (1130) ist und der transparente Bereich dazu ausgelegt ist, Lichtsignalen, die durch ein optisches Fingerabdruckmodul (202) übertragen oder empfangen werden, zu ermöglichen, durchzulaufen.

4. Anzeigebildschirm nach Anspruch 3, wobei der Fingerabdruckerkennungsbereich ferner mit ersten Scanleitungen (115) versehen ist, die elektrisch mit den ersten Dünnfilmtransistoren gekoppelt sind, der Peripheriebereich ferner mit zweiten Scanleitungen (116) versehen ist, die elektrisch mit den zweiten Dünnfilmtransistoren gekoppelt sind, und ein Intervall, mit dem die ersten Scanleitungen beabstandet sind, größer oder gleich einem Intervall ist, mit dem die zweiten Scanleitungen beabstandet sind.

5. Anzeigebildschirm nach Anspruch 4, wobei sich die ersten Scanleitungen in eine gleiche Richtung wie die zweiten Scanleitungen erstrecken, und die ersten Scanleitungen elektrisch mit den zweiten Scanleitungen gekoppelt sind.

6. Anzeigebildschirm nach Anspruch 5, wobei der Fingerabdruckerkennungsbereich ferner mit ersten Datenleitungen (117) versehen ist, die elektrisch mit den ersten Dünnfilmtransistoren gekoppelt sind, der Peripheriebereich ferner mit zweiten Datenleitungen (118) versehen ist, die elektrisch mit den zweiten Dünnfilmtransistoren gekoppelt sind, und ein Intervall, mit dem die ersten Datenleitungen beabstandet sind, größer oder gleich einem Intervall ist, mit dem die zweiten Datenleitungen beabstandet sind.

7. Anzeigebildschirm nach Anspruch 6, wobei sich die ersten Datenleitungen in eine gleiche Richtung wie die zweiten Datenleitungen erstrecken, und die ersten Datenleitungen elektrisch mit den zweiten Datenleitungen gekoppelt sind.

8. Anzeigebildschirm nach Anspruch 7, wobei der Fingerabdruckerkennungsbereich einem Teil der Anzeigeschicht entspricht und einem Randbereich der Anzeigeschicht entspricht, und sich der Peripheriebereich angrenzend zu dem Fingerabdruckerkennungsbereich befindet.

9. Anzeigebildschirm nach Anspruch 1, wobei der Fingerabdruckerkennungsbereich der gesamten Anzeigeschicht entspricht.

10. Anzeigebildschirm nach einem der Ansprüche 1 bis 9, der ferner eine Lichtabschirmungsschicht (120) umfasst, wobei die Lichtabschirmungsschicht an einer Seite der Anzeigeschicht von einem Benutzer entfernt angeordnet ist und ein Durchgangsloch definiert, wobei sich das Durchgangsloch an einer Position entsprechend dem Fingerabdruckerkennungsbereich befindet, und das optische Fingerabdruckmodul dazu ausgelegt ist, Lichtsignale durch das Durchgangsloch zu übertragen und zu empfangen.

11. Anzeigebildschirm nach Anspruch 10, wobei das Durchgangsloch einen orthographischen Projektionsbereich auf der Anzeigeschicht aufweist, der mit dem Fingerabdruckerkennungsbereich übereinstimmt.

12. Anzeigevorrichtung (200), die den Anzeigebildschirm nach einem der Ansprüche 1 bis 11, ein optisches Fingerabdruckmodul (202) und einen Rahmen (201) umfasst, wobei der Anzeigebildschirm und das optische Fingerabdruckmodul an dem Rahmen befestigt sind, sich das optische Fingerabdruckmodul an einer Seite des Anzeigebildschirms von einem Benutzer entfernt befindet, sich das optische Fingerabdruckmodul an einer Position entsprechend dem Fingerabdruckerkennungsbereich befindet, wobei der Fingerabdruckerkennungsbereich dazu ausgelegt ist, Lichtsignalen, die durch das optische Fingerabdruckmodul übertragen oder empfangen werden, zu ermöglichen, durchzulaufen.

13. Anzeigevorrichtung nach Anspruch 12, wobei das optische Fingerabdruckmodul einen Lichtemitter (203) und einen Lichtinduktor (204) umfasst, der Lichtemitter dazu ausgelegt ist, Lichtsignale zu emittieren, und der Lichtinduktor dazu ausgelegt ist, Lichtsignale zu empfangen, wobei Licht, das durch den Lichtemitter emittiert wird, durch den Fingerabdruckerkennungsbereich läuft, um auf Muster eines Fingers projiziert zu werden, wenn sich der Finger in Kontakt mit einer Oberfläche des Anzeigebildschirms befindet.

14. Mobiles Endgerät (300), das die Anzeigevorrichtung nach Anspruch 12 oder 13 umfasst.

## Revendications

1. Écran d'affichage (100, 400), comprenant une couche d'affichage (110), la couche d'affichage comportant une zone de reconnaissance d'empreinte digitale (111, 401) et une zone périphérique (112, 402) adjacente à la zone de reconnaissance d'empreinte digitale, la zone de reconnaissance d'empreinte digitale étant pourvue d'une pluralité de premiers composants d'attaque (113, 403), la zone périphérique étant pourvue d'une pluralité de deuxièmes composants d'attaque (114, 404), un intervalle (L1, L3) auquel la pluralité de premiers composants d'attaque sont agencés étant supérieur à un intervalle (L2, L4) auquel la pluralité de deuxièmes composants d'attaque sont agencés dans le but d'augmenter le facteur de transmission lumineuse de la zone de reconnaissance d'empreinte digitale, la zone de reconnaissance d'empreinte digitale permettant à des signaux lumineux de passer à travers ;
l'écran d'affichage (100, 400) étant un écran d'affichage OLED à matrice active ou un écran d'affichage OLED à matrice passive ; les premiers composants d'attaque étant des premiers transistors en couches minces et les deuxièmes composants d'attaque étant des deuxièmes transistors en couches minces lorsque l'écran d'affichage (100, 400) est l'écran d'affichage OLED à matrice active ; les premiers composants d'attaque étant des premières bandes d'anode et les deuxièmes composants d'attaque étant des deuxièmes bandes d'anode lorsque l'écran d'affichage (100, 400) est l'écran d'affichage OLED à matrice passive.

2. Écran d'affichage selon la revendication 1, dans lequel les premières transistors en couches minces sont agencés selon un réseau dans la zone de reconnaissance d'empreinte digitale.

3. Écran d'affichage selon la revendication 2, dans lequel une zone parmi les premiers transistors en couches minces est une zone transparente (1130), et la zone transparente est configurée pour permettre à des signaux lumineux émis ou reçus par un module optique d'empreinte digitale (202) de passer à travers.

4. Écran d'affichage selon la revendication 3, dans lequel la zone de reconnaissance d'empreinte digitale est pourvue en outre de premières lignes de balayage (115) couplées électriquement aux premiers transistors en couches minces, la zone périphérique est pourvue en outre de deuxièmes lignes de balayage (116) couplées électriquement aux deuxièmes transistors en couches minces, et un intervalle auquel les premières lignes de balayage sont espacées est supérieur ou égal à un intervalle auquel les deuxièmes lignes de balayage sont espacées.

5. Écran d'affichage selon la revendication 4, dans lequel les premières lignes de balayage s'étendent dans une même direction que les deuxièmes lignes de balayage, et les premières lignes de balayage sont couplées électriquement aux deuxièmes lignes de balayage.

6. Écran d'affichage selon la revendication 5, dans lequel la zone de reconnaissance d'empreinte digitale est pourvue en outre de premières lignes de données (117) couplées électriquement aux premiers transistors en couches minces, la zone périphérique est pourvue en outre de deuxièmes lignes de données (118) couplées électriquement aux deuxièmes transistors en couches minces, et un intervalle auquel les premières lignes de données sont espacées est supérieur ou égal à un intervalle auquel les deuxièmes lignes de données sont espacées.

7. Écran d'affichage selon la revendication 6, dans lequel les premières lignes de données s'étendent dans une même direction que les deuxièmes lignes de données, et les premières lignes de données sont couplées électriquement aux deuxièmes lignes de données.

8. Écran d'affichage selon la revendication 7, dans lequel la zone de reconnaissance d'empreinte digitale correspond à une partie de la couche d'affichage et correspond à une zone de bord de la couche d'affichage, et la zone périphérique est adjacente à la zone de reconnaissance d'empreinte digitale.

9. Écran d'affichage selon la revendication 1, dans lequel la zone de reconnaissance d'empreinte digitale correspondant à la couche d'affichage tout entière.

10. Écran d'affichage selon l'une quelconque des revendications 1 à 9, comprenant en outre une couche faisant écran à la lumière (120), la couche faisant écran à la lumière étant placée d'un côté de la couche d'affichage tourné à l'opposé d'un utilisateur et définissant un trou traversant, le trou traversant occupant une position correspondant à la zone de reconnaissance d'empreinte digitale, et le module optique d'empreinte digitale étant configuré pour émettre et recevoir des signaux lumineux à travers le trou traversant.

11. Écran d'affichage selon la revendication 10, dans lequel le trou traversant comporte une zone de projection orthographique sur la couche d'affichage qui coïncide avec la zone de reconnaissance d'empreinte digitale.

12. Dispositif d'affichage (200), comprenant un écran d'affichage selon l'une quelconque des revendications 1 à 11, un module optique d'empreinte digitale (202) et un cadre (201), l'écran d'affichage et le module optique d'empreinte digitale étant fixés sur le cadre, le module optique d'empreinte digitale se situant d'un côté de l'écran d'affichage tourné à l'opposé d'un utilisateur, le module optique d'empreinte digitale occupant une position correspondant à la zone de reconnaissance d'empreinte digitale, la zone de reconnaissance d'empreinte digitale étant configurée pour permettre à des signaux lumineux émis ou reçus par le module optique d'empreinte digitale de passer à travers.

13. Dispositif d'affichage selon la revendication 12, dans lequel le module optique d'empreinte digitale comprend un émetteur de lumière (203) et un capteur de lumière (204), l'émetteur de lumière est configuré pour émettre des signaux lumineux et le capteur de lumière est configuré pour recevoir des signaux lumineux, la lumière émise par l'émetteur de lumière passant à travers la zone de reconnaissance d'empreinte digitale pour être projetée sur des motifs d'un doigt lorsque le doigt est au contact d'une surface de l'écran d'affichage.

14. Terminal mobile (300), comprenant le dispositif d'affichage selon la revendication 12 ou 13.
